# EUROPEAN PATENT APPLICATION

(11) **EP 4 737 188 A1**
(43) Date of publication of application: **06.05.2026**
(21) Application number: 25207610.4
(22) Date of filing: 08.10.2025
(51) Int. Cl.: B60L 3/00, B60L 3/12, B60L 55/00, B60L 3/04, B60L 53/14, B60L 53/22, B60L 53/60, B60L 53/66, G01R 31/52

(54) **CONTROL SYSTEM FOR VEHICLE**

(30) Priority: 30.10.2024 JP 2024190336
(71) Applicant: TOYOTA JIDOSHA KABUSHIKI KAISHA, Toyota-shi, Aichi-ken 471-8571 (JP)
(72) Inventor: NAKAMURA, Tohru, TOYOTA-SHI, AICHI-KEN, 471-8571 (JP)
(74) Representative: Cabinet Beau de Loménie

(57) **Abstract**

A vehicle (10) includes a battery (120) capable of charging and discharging power for traveling of the vehicle, and a BOBC (130) including a bidirectional inverter (132) that converts DC power of the battery into AC power, and outputting the converted AC power to an outside of the vehicle. An insulation resistance reduction detection unit (133) senses a reduction in insulation resistance from an AC side of the bidirectional inverter to the battery. When discharging from the BOBC to the outside is performed, a processor (1311, 111) senses a reduction in insulation resistance (S132) using the insulation resistance reduction detection unit, before connection of a relay (134, 234) that switches between a cut-off state and a connected state of an electric path connecting the AC side of the bidirectional inverter and the outside of the vehicle (S135), and, when a reduction in insulation resistance is not sensed, the processor issues a command to switch the relay to the connected state (S133 to S135, S193 to S195, S213 to S214).

## Description

### CROSS REFERENCE TO RELATED APPLICATIONS

This application is based on Japanese Patent Application No. 2024-190336 filed on October 30, 2024 with the Japan Patent Office, the entire contents of which are hereby incorporated by reference.

### BACKGROUND

### Field

The present disclosure relates to a control system for a vehicle, and more particularly, to a control system for a vehicle including a power storage device capable of charging and discharging power for traveling of the vehicle.

### Description of the Background Art

Conventionally, in a vehicle including a power storage device capable of charging and discharging power, charging or discharging is performed in accordance with a sequence that can ensure a standby period before insulation diagnosis after communication for starting charging or discharging (see, for example, Japanese Patent Laying-Open No. 2023-091287). A vehicle in Japanese Patent Laying-Open No. 2023-091287 includes a relay that switches between opening and closing of a contact that cuts off or connects an electric path between an external device and a power storage device, and a control device that controls the relay and charging and discharging of the power storage device. The control device performs welding diagnosis for the contact after controlling the contact of the relay to be opened, determines whether or not the welding diagnosis is normally finished, and, when it determines that the welding diagnosis is not normally finished at the time of controlling the contact to be closed, the control device performs the welding diagnosis in a standby period. Thereby, when the welding diagnosis for the contact is not normally finished after the contact of the relay is controlled to be opened, the welding diagnosis is performed in the standby period before insulation diagnosis after communication for starting charging or discharging. As a result, it is possible to appropriately perform the welding diagnosis when a sequence for charging or discharging is repeated without user intervention.

### SUMMARY

When the vehicle in Japanese Patent Laying-Open No. 2023-091287 is used for AC-V2G (Alternating Current Vehicle-To-Grid), grounding is established not on the side of the vehicle but on the side of a power grid, which has caused a problem that it is not possible to sense an electric leakage and detect a reduction in insulation resistance on the side of the vehicle.

The present disclosure has been made to solve the aforementioned problem, and an object of thereof is to provide a control system for a vehicle capable of ensuring electrical safety during discharging from the vehicle to the outside.

A control system according to the present disclosure is a control system for a vehicle. The vehicle includes a power storage device capable of charging and discharging power for traveling of the vehicle, and a discharging unit including an inverter that converts direct current (DC) power of the power storage device into AC power, and outputting the converted AC power to an outside of the vehicle. The control system includes a processor, and a sensing unit that senses a reduction in insulation resistance from an AC side of the inverter to the power storage device. When discharging from the discharging unit to the outside is performed, the processor senses a reduction in insulation resistance using the sensing unit, before connection of a relay that switches between a cut-off state and a connected state of an electric path connecting the AC side of the inverter and the outside of the vehicle, and, when a reduction in insulation resistance is not sensed, the processor issues a command to switch the relay to the connected state.

With such a configuration, when discharging from the discharging unit of the vehicle to the outside is performed, a reduction in insulation resistance is sensed using the sensing unit that senses a reduction in insulation resistance from the AC side of the inverter to the power storage device, before connection of the relay that switches between the cut-off state and the connected state of the electric path connecting the AC side of the inverter and the outside of the vehicle, and, when a reduction in insulation resistance is not sensed, the relay is switched to the connected state. Accordingly, a reduction in insulation resistance, which is a cause of an electric leakage, is sensed before discharging from the vehicle to the outside, without adding an electric leakage sensor on the side of the vehicle. As a result, it is possible to provide a control system for a vehicle capable of ensuring electrical safety during discharging from the vehicle to the outside.

The processor may sense a reduction in insulation resistance, while exchanging information necessary for discharging between the discharging unit and an external charging/discharging device.

With such a configuration, it is possible to shorten a time taken until discharging can be started, as compared with a case where exchange of the information necessary for discharging and sensing of a reduction in insulation resistance are not performed in parallel.

After the connection of the relay, the processor may prohibit sensing of a reduction in insulation resistance using the sensing unit.

With such a configuration, sensing of a reduction in insulation resistance is not performed after the connection of the relay. As a result, it is possible to prevent erroneous sensing of a reduction in insulation resistance.

The relay may be included in the discharging unit. With such a configuration, the vehicle can independently perform sensing of a reduction in insulation resistance.

The relay may be provided outside the vehicle, and the sensing unit may further sense a reduction in insulation resistance from the relay to the inverter.

With such a configuration, it is also possible to sense a reduction in insulation resistance to the relay outside the vehicle.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a configuration diagram schematically showing a power system according to an embodiment of the present disclosure.
Fig. 2 is a diagram for illustrating a case where a BEV in the present embodiment is connected to a load.
Fig. 3 is a diagram for illustrating a case where the BEV in the present embodiment is connected to a power grid via an EVSE.
Fig. 4 is a flowchart showing a flow of processing when V2G is started in the present embodiment.

### DESCRIPTION OF THE PREFERRED EMBODIMENTS

Hereinafter, an embodiment of the present disclosure will be described in detail with reference to the drawings. In the drawings, the same or corresponding parts will be designated by the same reference numerals, and the description thereof will not be repeated.

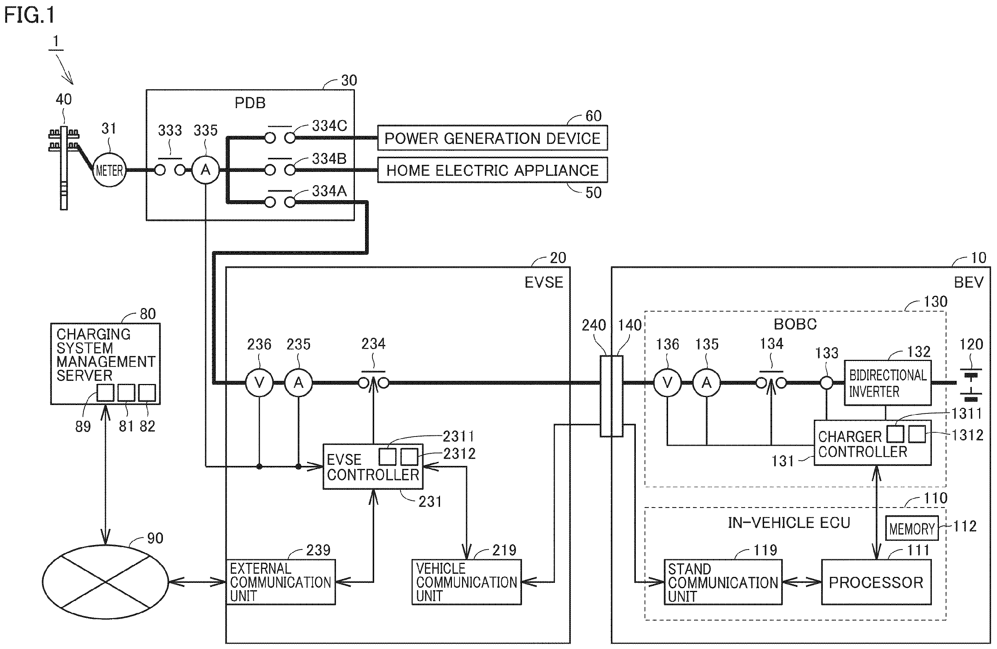

Fig. 1 is a configuration diagram schematically showing a power system 1 according to the embodiment of the present disclosure. Referring to Fig. 1, of lines connecting components, a ultrathick solid line which is the thickest indicates a power line, and a solid line thinner than the ultrathick solid line indicates a signal line of a digital signal or an analog signal.

Power system 1 includes an electric vehicle (hereinafter referred to as a "battery electric vehicle (BEV)") 10, electric vehicle supply equipment (EVSE) 20, a power distribution board (hereinafter referred to as a "PDB") 30, a meter 31, a power grid 40, a home electric appliance 50, a power generation device 60, a charging system management server 80, and a communication network 90.

Power grid 40 is a system that integrates a power generation facility, a power transformation facility, a power transmission facility, and a power distribution facility for supplying power to consumers. Power grid 40 supplies power from a power generation facility and a power transformation facility of a supplier to consumers via a power transmission facility, and supplies power from a consumer to another consumer.

Meter 31, PDB 30, and EVSE 20 are installed at a consumer. BEV 10 is used by the consumer. Meter 31 measures the amount of power exchanged between the power supplier and the consumer, and transmits the measured amount of power to the supplier or the like.

PDB 30 includes a main breaker 333, a current sensor 335, and electric leakage circuit breakers (hereinafter referred to as "residual current devices (RCD)") 334A to 334C. Main breaker 333 is provided on the side of meter 31 of power distribution board 30. Main breaker 333 detects a current supplied from the supplier to the consumer, and, when an abnormality occurs, main breaker 333 cuts off a circuit connecting the consumer and the supplier. Current sensor 335 measures the current supplied from the supplier to the consumer and a current outputted from the consumer to power grid 40, and outputs a signal indicating each measured current to an EVSE controller 231 of EVSE 20.

RCDs 334A to 334C sense an electric leakage in circuits between themselves and the appliances (EVSE 20, home electric appliance 50, and power generation device 60 in the present embodiment) respectively connected to RCDs 334A to 334C, and, when they sense an electric leakage, they switch the circuits between themselves and the appliances connected thereto to a cut-off state.

Home electric appliance 50 is an electric appliance mainly used at home, and is, for example, a refrigerator, a washing machine, an air conditioner, a microwave oven, a rice cooker, an audio appliance, an information appliance, or the like. Home electric appliance 50 operates using power supplied from PDB 30.

Power generation device 60 is a device that can generate power and can be installed at the consumer, such as a solar power generation device, a wind power generation device, an emergency self-power generation device, a fuel cell, and a cogeneration system, for example. The cogeneration system is a system that generates power using a diesel engine, a gas engine, a gas turbine, or a fuel cell, and utilizes exhaust heat for hot water supply, cooling and heating, or the like. Power generation device 60 converts generated DC power into AC power, and outputs the AC power to power distribution board 30.

EVSE 20 is a device that bidirectionally exchanges power with BEV 10. EVSE 20 includes EVSE controller 231, an RCD 234, a current sensor 235, a voltage sensor 236, a vehicle communication unit 219, an external communication unit 239, and a connector 240. Connector 240 is configured to be connectable to an inlet 140 of BEV 10, and is connected to a main body of EVSE 20 using a cable.

EVSE controller 231 includes a processor 2311 and a memory 2312. Processor 2311 controls the entire EVSE 20 in accordance with a program stored in memory 2312.

RCD 234 senses an electric leakage in a circuit of power lines between connector 240 and PDB 30, to which RCD 234 is connected, and, when it senses an electric leakage, it switches the circuit to the cut-off state. Further, RCD 234 is controlled by EVSE controller 231 to switch the circuit to which RCD 234 is connected to a connected state or the cut-off state.

Current sensor 235 measures a current of power exchanged between BEV 10 and PDB 30, and outputs a signal indicating the measured current to EVSE controller 231. Voltage sensor 236 measures a voltage of the power exchanged between BEV 10 and PDB 30, and outputs a signal indicating the measured voltage to EVSE controller 231.

Vehicle communication unit 219 is controlled by EVSE controller 231 to communicate with BEV 10 via connector 240. External communication unit 239 is controlled by EVSE controller 231 to communicate with charging system management server 80 via communication network 90. Communication network 90 includes a private network such as a local area network (LAN) or a virtual private network (VPN), and a public network such as the Internet, a public line, or a public wireless LAN.

BEV 10 is a vehicle that travels using power of a battery 120. BEV 10 includes an in-vehicle ECU 110, battery 120, a bidirectional in-vehicle charger (hereinafter referred to as a "bidirectional on board charger (BOBC)") 130, and inlet 140. Inlet 140 is configured such that connector 240 of EVSE 20 is connectable thereto.

In-vehicle ECU (electronic control unit) 110 includes a processor 111, a memory 112, and a stand communication unit 119. Processor 111 controls the entire BEV 10 in accordance with a program stored in memory 112. Stand communication unit 119 is controlled by processor 111 to communicate with EVSE 20 via inlet 140.

BOBC 130 converts AC power from a power feeding facility such as EVSE 20 into DC power and supplies the DC power to battery 120, and converts DC power of battery 120 into AC power and supplies the AC power to an external device such as EVSE 20. BOBC 130 includes a charger controller 131, a bidirectional inverter 132, a cut-off relay 134, a current sensor 135, and a voltage sensor 136.

Charger controller 131 includes a processor 1311 and a memory 1312. Processor 1311 controls BOBC 130 in accordance with a program stored in memory 1312.

Bidirectional inverter 132 is controlled by charger controller 131, to convert the AC power supplied to BOBC 130 into DC power having a voltage of battery 120 and supply the DC power to battery 120, and to convert the DC power from battery 120 into AC power having a prescribed voltage and supply the AC power from BOBC 130 to the external device via inlet 140.

Cut-off relay 134 is controlled by charger controller 131 to switch a circuit of high-voltage power lines connecting inlet 140 and battery 120 to the connected state or the cut-off state.

Current sensor 135 measures a current of the power exchanged between EVSE 20 and battery 120, and outputs a signal indicating the measured current to charger controller 131. Voltage sensor 136 measures a voltage of the power exchanged between EVSE 20 and battery 120, and outputs a signal indicating the measured voltage to charger controller 131.

Charging system management server 80 is a server that manages devices such as EVSE 20 in power system 1. Charging system management server 80 includes a processor 81, a storage device 82, and a communication unit 89. Processor 81 of charging system management server 80 manages the devices such as EVSE 20 in accordance with a program stored in storage device 82, and controls communication unit 89 to communicate with the devices such as EVSE 20 via communication network 90.

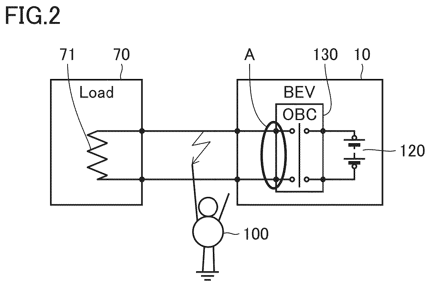

Fig. 2 is a diagram for illustrating a case where BEV 10 in the present embodiment is connected to a load 70. Referring to Fig. 2, load 70 includes a component 71 that consumes power supplied from BEV 10. Load 70 is connectable to BEV 10 to receive the power.

There is a case where a sheath of a cable of a power line for connecting load 70 and BEV 10 may be broken. When the power is supplied from BEV 10 to load 70 in V2L (Vehicle to Load), an electric leakage may occur if a person 100 touches the broken sheath of the cable. Since an electric leakage does not occur in BEV 10 in general, BEV 10 is not provided with an electric leakage detection function. Accordingly, it is not possible to detect an electric leakage at an A portion between both terminals of BOBC 130. However, since BOBC 130 of BEV 10 in the present embodiment is provided with an insulation resistance reduction detection unit 133 as shown in Fig. 1, it is possible to detect a reduction in insulation resistance at the A portion.

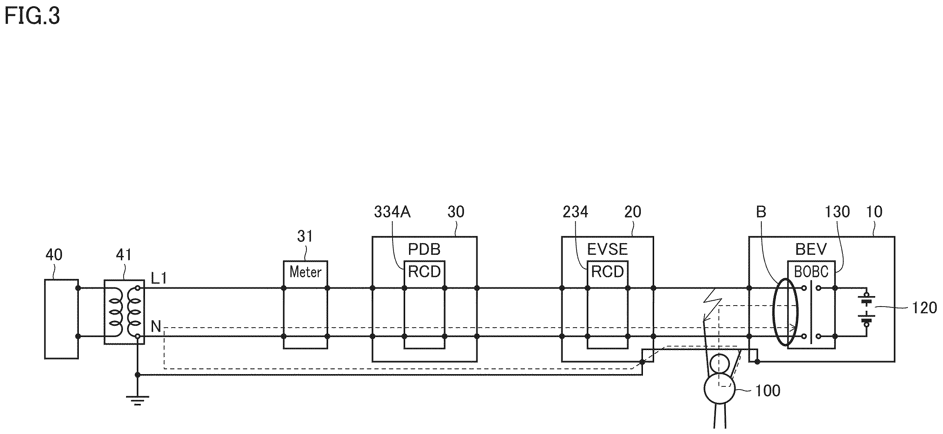

Fig. 3 is a diagram for illustrating a case where BEV 10 in the present embodiment is connected to power grid 40 via EVSE 20. Referring to Fig. 3, a transformer 41 is provided between meter 31 and power grid 40. Transformer 41 is installed at a power pole, for example. Transformer 41 changes a voltage of AC power between power grid 40 and meter 31. In general, a voltage of power grid 40 is higher than a voltage on the side of meter 31. On a secondary side of transformer 41 (on the side of meter 31), an L1 terminal on a non-ground side and an N terminal on a ground side are provided. The N terminal is grounded. A casing of EVSE 20 is also grounded. In the case of Fig. 3, a body of BEV 10 is grounded via inlet 140, connector 240, and a body of EVSE 20.

There is a case where a sheath of a cable for connecting BEV 10 and EVSE 20 may be broken. When power is exchanged between BEV 10 and power grid 40 in V2G (Vehicle to Grid), an electric leakage may occur if person 100 touches the broken sheath of the cable. In this case, as indicated by a broken line in Fig. 3, a difference in voltage is not generated at both phases of a B portion between both terminals of BOBC 130, and thus it is not possible to sense an electric leakage. It should be noted that, since EVSE 20 and PDB 30 have RCDs 234 and 334A, respectively, it is possible to sense an electric leakage and cut off the circuits. Further, since the side of power grid 40 is grounded at the time of V2G, it is not possible to sense a reduction in insulation resistance of BEV 10 in a state where BOBC 130 is connected to power grid 40.

Thus, when BEV 10 is used for AC-V2G (Alternating Current Vehicle-To-Grid), grounding is established not on the side of BEV 10 but on the side from EVSE 20 to power grid 40, which has caused a problem that it is not possible to sense an electric leakage and detect a reduction in insulation resistance on the side of BEV 10.

Accordingly, a control system including charger controller 131 and in-vehicle ECU 110 includes processor 1311, 111, and insulation resistance reduction detection unit 133 that senses a reduction in insulation resistance from an AC side of bidirectional inverter 132 to battery 120. When discharging from BOBC 130 to the outside is performed, the processor senses a reduction in insulation resistance using the insulation resistance reduction detection unit, before connection of a relay (cut-off relay 134, RCD 234) that switches between a cut-off state and a connected state of an electric path connecting the AC side of bidirectional inverter 132 and the outside of BEV 10, and, when a reduction in insulation resistance is not sensed, the processor issues a command to switch the relay to the connected state.

Thereby, when discharging from BOBC 130 of BEV 10 to the outside is performed, a reduction in insulation resistance is sensed using insulation resistance reduction detection unit 133 that senses a reduction in insulation resistance from the AC side of bidirectional inverter 132 to battery 120, before connection of the relay that switches between the cut-off state and the connected state of the electric path connecting the AC side of bidirectional inverter 132 and the outside of BEV 10, and, when a reduction in insulation resistance is not sensed, the relay is switched to the connected state. Accordingly, a reduction in insulation resistance, which is a cause of an electric leakage, is sensed before discharging from BEV 10 to the outside, without adding an electric leakage sensor on the side of BEV 10. As a result, it is possible to ensure electrical safety during discharging from BEV 10 to the outside.

Referring back to Fig. 1, charger controller 131 further includes insulation resistance reduction detection unit 133. Insulation resistance reduction detection unit 133 detects a reduction in insulation resistance of a circuit to which insulation resistance reduction detection unit 133 is connected, and outputs a detection result to charger controller 131. When connector 240 of EVSE 20 is not connected to inlet 140, the circuit to which insulation resistance reduction detection unit 133 is connected is a circuit from battery 120 to inlet 140 on the AC side of bidirectional inverter 132. When connector 240 is connected to inlet 140, the circuit to which insulation resistance reduction detection unit 133 is connected is further a circuit at least including from connector 240 of EVSE 20 to RCD 234, and may be a circuit including from connector 240 of EVSE 20 to meter 31.

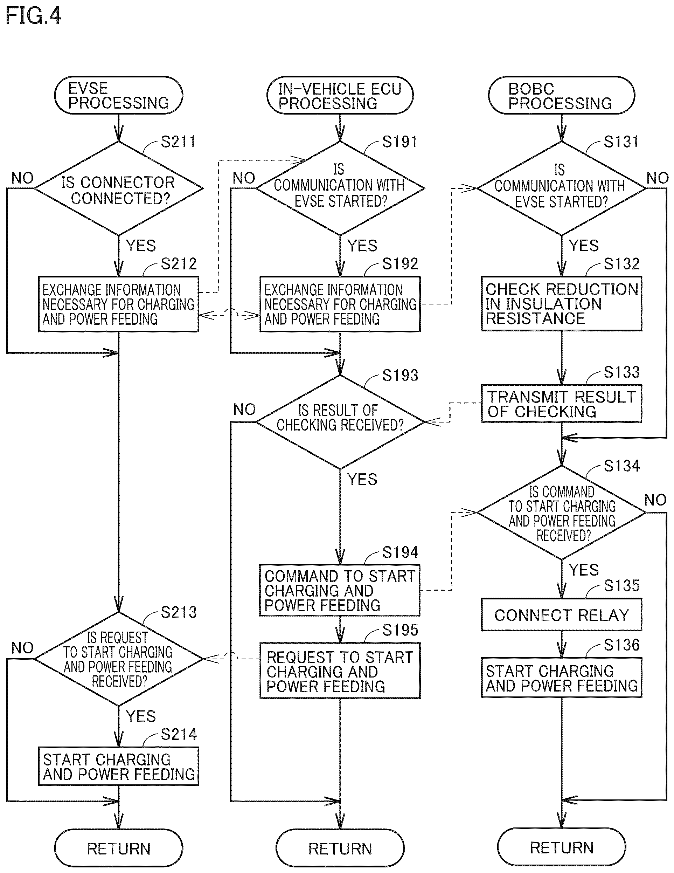

Fig. 4 is a flowchart showing a flow of processing when V2G is started in the present embodiment. Referring to Fig. 4, EVSE processing is called from higher-order processing for each prescribed cycle and performed by EVSE controller 231 of EVSE 20. In-vehicle ECU processing is called from higher-order processing for each prescribed cycle and performed by in-vehicle ECU 110 of BEV 10. BOBC processing is called from higher-order processing for each prescribed cycle and performed by charger controller 131 of BOBC 130.

In EVSE 20, processor 2311 of EVSE controller 231 determines whether or not connector 240 is connected to inlet 140 of BEV 10 (step S211). When processor 2311 determines that connector 240 is connected (YES in step S211), processor 2311 starts communication for exchanging information necessary for charging and power feeding with in-vehicle ECU 110 of BEV 10 (step S212).

In BEV 10, processor 111 of in-vehicle ECU 110 determines whether or not the communication with EVSE 20 is started (step S191). When processor 111 determines that the communication with EVSE 20 is started (YES in step S191), processor 111 starts the communication for exchanging the information necessary for charging and power feeding with EVSE controller 231 of EVSE 20 (step S192).

In BOBC 130 of BEV 10, processor 1311 of charger controller 131 determines whether or not the communication for exchanging the information necessary for charging and power feeding is started between EVSE 20 and BEV 10 (step S131). When processor 1311 determines that the communication with EVSE 20 is started (YES in step S131), processor 1311 checks a reduction in insulation resistance of BEV 10 using a detection result from insulation resistance reduction detection unit 133 (step S132). Then, processor 1311 transmits a result of checking of a reduction in insulation resistance to in-vehicle ECU 110 (step S133).

In BEV 10, processor 111 of in-vehicle ECU 110 determines whether or not the result of checking of a reduction in insulation resistance is received from BOBC 130 (step S193). When processor 111 determines that the result of checking is received (YES in step S193), processor 111 transmits a command to start charging and power feeding to BOBC 130 (step S194). Further, processor 111 controls stand communication unit 119 to transmit a request to start charging and power feeding to EVSE 20 (step S195). When processor 111 determines that the result of checking is not received (NO in step S193), or after step S195, processor 111 returns the processing to be performed to the higher-order processing from which the in-vehicle ECU processing was called.

In BOBC 130 of BEV 10, when processor 1311 of charger controller 131 determines that current timing is not timing at which the communication with the EVSE is started (NO in step S131), or after step S133, processor 1311 determines whether or not the command to start charging and power feeding is received from in-vehicle ECU 110 (step S134). When processor 1311 determines that the command to start charging and power feeding is received (YES in step S134), processor 1311 switches cut-off relay 134 to the connected state (step S135). Then, processor 1311 controls bidirectional inverter 132 and the like of BOBC 130 to start charging and power feeding from and to EVSE 20 (step S136). When processor 1311 determines that the command to start charging and power feeding is not received (NO in step S134), or after step S136, processor 1311 returns the processing to be performed to the higher-order processing from which the BOBC processing was called.

In EVSE 20, processor 2311 of EVSE controller 231 determines whether or not the request to start charging and power feeding from in-vehicle ECU 110 is received by vehicle communication unit 219 (step S213). When processor 2311 determines that the request to start charging and power feeding is received (YES in step S213), processor 2311 switches RCD 234 to the connected state, and controls EVSE 20 to start charging and power feeding from and to BEV 10 (step S214). When processor 2311 determines that the request to start charging and power feeding is not received (NO in step S213), or after step S214, processor 2311 returns the processing to be performed to the higher-order processing from which the EVSE processing was called.

### [Modifications]

(1) In the embodiment described above, the vehicle is BEV 10. However, the present disclosure is not limited thereto, and the vehicle may be any other type of vehicle, for example, a plug-in hybrid vehicle (PHEV: Plug-in Hybrid Electric Vehicle) or a fuel cell vehicle (FCEV: Fuel Cell Electric Vehicle) having a plug-in function, as long as the vehicle is connectable to EVSE 20.
(2) In the embodiment described above, EVSE 20 is installed at the consumer. However, the present disclosure is not limited thereto, and EVSE 20 may be installed at another facility, for example, a public facility such as a power feeding facility.
(3) In the embodiment described above, BOBC 130 includes bidirectional inverter 132. However, the present disclosure is not limited thereto, and BOBC 130 may include different inverters respectively used for charging and discharging battery 120.
(4) The embodiment described above can be considered as disclosure of a vehicle such as BEV 10, can be considered as disclosure of a control system for the vehicle such as charger controller 131 and in-vehicle ECU 110, and can be considered as disclosure of a control method or a control program performed in the vehicle or the control system.

### [Summary]

(1) As shown in Fig. 1, the control system (for example, charger controller 131, in-vehicle ECU 110) is a control system for a vehicle (for example, BEV 10, a PHEV, an FCEV). As shown in Fig. 1, the vehicle includes battery 120 capable of charging and discharging power for traveling of the vehicle, and BOBC 130 including bidirectional inverter 132 that converts DC power of battery 120 into AC power, and outputting the converted AC power to an outside of the vehicle. As shown in Fig. 1, the control system includes a processor (for example, processor 1311 of charger controller 131, processor 111 of in-vehicle ECU 110), and insulation resistance reduction detection unit 133 that senses a reduction in insulation resistance from an AC side of bidirectional inverter 132 to battery 120. As shown in Fig. 4, when discharging from BOBC 130 to the outside is performed, the processor senses a reduction in insulation resistance (for example, step S132) using insulation resistance reduction detection unit 133, before connection of a relay (for example, cut-off relay 134 of BOBC 130, RCD 234 of EVSE 20) that switches between a cut-off state and a connected state of an electric path connecting the AC side of bidirectional inverter 132 and the outside of the vehicle (for example, step S135), and, when a reduction in insulation resistance is not sensed, the processor issues a command to switch the relay to the connected state (for example, steps S133 to S135, steps S193 to S195, steps S213 to S214).

Thereby, when discharging from BOBC 130 of the vehicle to the outside is performed, a reduction in insulation resistance is sensed using insulation resistance reduction detection unit 133 that senses a reduction in insulation resistance from the AC side of bidirectional inverter 132 to battery 120, before connection of the relay that switches between the cut-off state and the connected state of the electric path connecting the AC side of bidirectional inverter 132 and the outside of the vehicle, and, when a reduction in insulation resistance is not sensed, the relay is switched to the connected state. Accordingly, a reduction in insulation resistance, which is a cause of an electric leakage, is sensed before discharging from the vehicle to the outside, without adding an electric leakage sensor on the side of the vehicle. As a result, it is possible to ensure electrical safety during discharging from the vehicle to the outside.

(2) As shown in Fig. 4, the processor may sense a reduction in insulation resistance (for example, step S132), while exchanging information necessary for discharging between BOBC 130 and external EVSE 20 (for example, while performing steps S211 to S212 and steps S191 to S192).

Thereby, it is possible to shorten a time taken until discharging can be started, as compared with a case where exchange of the information necessary for discharging and sensing of a reduction in insulation resistance are not performed in parallel.

(3) As shown in Fig. 4, after the connection of the relay, the processor may prohibit sensing of a reduction in insulation resistance using insulation resistance reduction detection unit 133 (for example, the processor may not perform the processing in step S132).

Thereby, sensing of a reduction in insulation resistance is not performed after the connection of the relay. As a result, it is possible to prevent erroneous sensing of a reduction in insulation resistance. It should be noted that, at the time of V2L, sensing of a reduction in insulation resistance using insulation resistance reduction detection unit 133 may be continued even during charging and power feeding. Further, at the time of V2G, after sensing of a reduction in insulation resistance is prohibited, an electric leakage is sensed by RCD 234 of EVSE 20 and RCDs 334A to 334C of PDB 30.

(4) As shown in Fig. 1, the relay (for example, cut-off relay 134 of BOBC 130 of BEV 10) may be included in BOBC 130. Thereby, the vehicle can independently perform sensing of a reduction in insulation resistance.

(5) As shown in Fig. 1, the relay (for example, RCD 234 of EVSE 20) may be provided outside the vehicle, and insulation resistance reduction detection unit 133 may further sense a reduction in insulation resistance from the relay to bidirectional inverter 132.

Thereby, it is also possible to sense a reduction in insulation resistance to the relay outside the vehicle.

Although the embodiment of the present disclosure has been described, it should be understood that the embodiment disclosed herein is illustrative and non-restrictive in every respect. The scope of the present disclosure is defined by the scope of the claims, and is intended to include any modifications within the scope and meaning equivalent to the scope of the claims.

## Claims

1. A control system (131, 110) for a vehicle (10),
the vehicle (10) including
a power storage device (120) capable of charging and discharging power for traveling of the vehicle (10), and
a discharging unit (130) including an inverter (132) for converting DC power of the power storage device into AC power, and outputting the converted AC power to an outside of the vehicle (10),
the control system (131, 110) comprising:
a processor (1311, 111); and
a sensing unit (133) for sensing a reduction in insulation resistance from an AC side of the inverter (132) to the power storage device (120), wherein
the processor (1311, 111) is configured to sense a reduction in insulation resistance (S132) using the sensing unit, when discharging from the discharging unit to the outside is performed, before connection of a relay (134, 234) configured to switch between a cut-off state and a connected state of an electric path connecting the AC side of the inverter (132) and the outside of the vehicle (10), and
the processor (1311, 111) is configured to issue a command to switch the relay to the connected state when a reduction in insulation resistance is not sensed.

2. The control system (131, 110) according to claim 1, wherein the processor (1311, 111) is configured to sense a reduction in insulation resistance, while exchanging information necessary for discharging between the discharging unit (130) and an external charging/discharging device.

3. The control system (131, 110) according to any one of claims 1 or 2, wherein the processor (1311, 111) is configured to prohibit sensing of a reduction in insulation resistance using the sensing unit (133) after the connection of the relay (134, 234).

4. The control system (131, 110) according to any one of claims 1 to 3, wherein the relay (134) is included in the discharging unit (130).

5. The control system (131, 110) according to claim 1, wherein
the relay (234) is provided outside the vehicle (10), and
the sensing unit (133) is configured to further sense a reduction in insulation resistance from the relay (234) to the inverter (132).
